# EUROPEAN PATENT APPLICATION

(11) **EP 3 409 813 A1**
(43) Date of publication of application: **05.12.2018**
(21) Application number: 17173938.6
(22) Date of filing: 01.06.2017
(51) Int. Cl.: C23C 18/12, H01L 31/0352, B82Y 20/00, C09D 1/00, H01L 51/50

(54) **DEVICE CONTAINING METAL OXIDE-CONTAINING LAYERS**

(71) Applicant: Evonik Degussa GmbH, 45128 Essen (DE)
(72) Inventor: Steiger, Jurgen Dr., 64285 Darmstadt (DE); Merkulov, Alexey Dr., 45772 Marl (DE); Anselmann, Ralf Dr., 59348 Lüdinghausen (DE); Renner, Gerhard Dr., 64589 Stockstadt am Rhein (DE)

(57) **Abstract**

The present invention is directed to process for preparing a device comprising a first layer and a first electrode, the method comprising forming the first layer over a first electrode by applying a liquid anhydrous composition comprising at least one metal oxo alkoxide and at least one solvent, onto a surface, the surface being selected from the surface of the first electrode or the surface of a layer being located over the first electrode, optionally drying the composition, and converting the composition to a metal oxide-containing first layer, and forming a second electrode over the first device layer, wherein the method further includes forming a layer comprising quantum dots over the first electrode before or after the formation of the first layer and to the device itself.

## Description

The present invention is directed to process for preparing a device comprising a first layer and a first electrode, the method comprising forming the first layer over a first electrode by applying a liquid anhydrous composition comprising at least one metal oxo alkoxide and at least one solvent, onto a surface, the surface being selected from the surface of the first electrode or the surface of a layer being located over the first electrode, optionally drying the composition, and converting the composition to a metal oxide-containing first layer, and forming a second electrode over the first device layer, wherein the method further includes forming a layer comprising quantum dots over the first electrode before or after the formation of the first layer and to the device itself. In the present invention the terms "device layer" and "layer" are used interchangeable.

### Technical field of the invention

The invention is related to the technical field of devices that comprise quantum dots.

### Summary of the invention

The present invention provides a process for preparing a device, the process comprising:
Forming a first layer over a first electrode, the layer comprising a metal oxide formed from a liquid non-aqueous solution containing at least one metal oxide precursor, and forming a second electrode over the first layer, wherein the method further includes forming a layer comprising quantum dots over the first electrode before or after the formation of the first layer. Preferred metal oxides included in the device layer are indium oxide, zinc oxide, gallium oxide, yttrium oxide, tin oxide, germanium oxide, scandium oxide, titanium oxide, zirconium oxide, aluminum oxide, wolfram oxide, molybdenum oxide, nickel oxide, chromium oxide, iron oxide, hafnium oxide, tantalum oxide, niobium oxide or copper oxide, or mixtures thereof.
The first layer is preferably a charge transport layer. For example, the first layer may comprise a material capable of transporting electrons (also referred to herein as an electron transport layer). The first layer may comprise a material capable of transporting electrons and injecting electrons (also referred to herein as an electron transport and injection layer). The first layer may comprise a material capable of transporting holes (also referred to herein as hole transporting layer). The first layer may comprise a material capable of transporting holes and injecting holes (also referred to herein as a hole transport and injection layer).

The process according to the invention may further include a step of forming a second layer (e.g. a second charge transport layer). The second layer is preferably formed such that the layer comprising the quantum dots is disposed between the first and second device layer.

The process according to the present invention includes the formation of a first layer from a liquid anhydrous composition containing at least one metal oxide precursor.

One of the electrodes may be formed on a substrate on which the device is build.

The process optionally further comprises formation of other optional layers, including, for example, but not limited to, charge blocking layers, charge injection layers, charge confinement layers, exciton confinement layers etc. in or to form the device.

The present invention is also directed to a device, preferably prepared by the process of the invention. The device comprises a first layer formed over a first electrode, the first layer comprising a metal oxide, preferably formed from a liquid anhydrous composition containing at least one metal oxide precursor, a second electrode over the first layer, and a layer comprising quantum dots disposed between the first layer and one of the two electrodes.

Preferred metal oxides being present in the first device layer include zinc oxide, titanium oxide, indium oxide, gallium oxide, tin oxide, aluminum oxide, hafnium oxide, yttrium oxide, germanium oxide zirconium oxide, nickel oxide, copper oxide, tantalum oxide, niobium oxide, or scandium oxide or mixtures thereof. The first layer can be a charge transport layer as defined above. The device can further include a second layer (e.g., a charge transport layer) such that the layer comprising quantum dots is present between the first and second layer layers.

The device may further include a substrate. For example, the first or second electrode may be formed on a substrate. The substrate may be selected from: glass, plastic, quartz, metal, semiconductor, dielectric, paper, wafer. Other substrate materials may be used. Plastic can comprise PE, PP, PET, PEN, Polyimide, PEEK, Polyamide. The substrate may be a flexible substrate. The substrate may contain a barrier layer. The barrier layer may comprise silicon oxide, silicon nitride, alluminum oxide and other oxides.

The device can further comprise other optional layers, including, for example, but not limited to, charge blocking layers, charge injecting layers, charge confinement layers, exciton confinement layers, etc. The device can comprise or be a light-emitting device where the emissive layer comprises quantum dots.

The foregoing, and other aspects described herein, all constitute embodiments of the present invention.

It should be appreciated by those persons having ordinairy skills in the art(s) to which the present invention relates that any of the features described hierin in respect of any particular aspect and/or embodiment of the present invention can be combined with one or more of any of the other features of any other aspects and/or embodiments of the present invention described herein, with modifications as appropriate to ensure compatibility of the combinations. Such combinations are considered to be part of the present invention contemplated by this disclosure.

It is to be understood that both the foregoing general description and the following detailed description are exemplary and explanatory only and are not restrictive of the invention as claimed.

Other embodiments will be apparent to those skilled in the art from consideration of the description and drawings, from the claims, and from practice of the invention disclosed herein.

In the drawings:

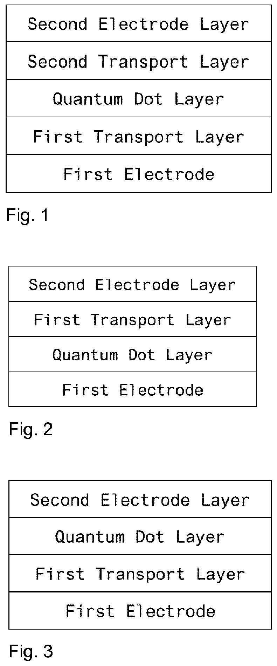

Fig. 1: Shows an example for a device (structure) in accordance with the invention with top and bottom (transport layer) configuration.
Fig. 4: Shows another example for a device (structure) in accordance with the invention with top only configuration.

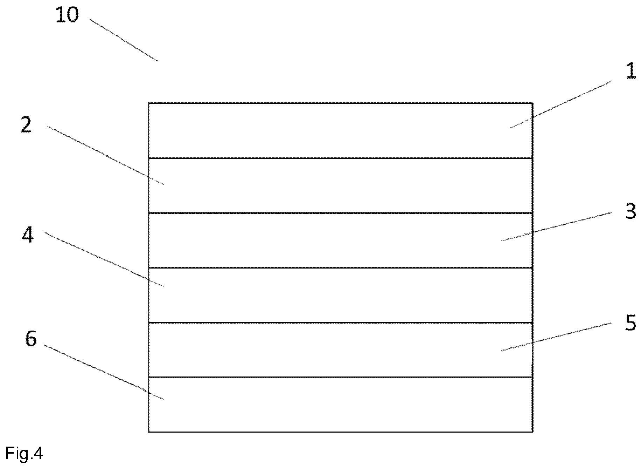

Fig. 4: Shows another example for a device (structure) in accordance with the invention with bottom only configuration.
Fig. 4: Shows another example for a device in accordance with the present invention. 10 is the device, 6 substrate, 5 first electrode layer, 4 first transport layer, 3 quatum dot emitter layer, 2 second trasport layer, 1 second electrode layer.

The attached figures are simplified representations presented for purposes of illustration only; actual structures may differ in numerous respects, including, e.g., relative scale, etc.

For a better understanding to the present invention, together with other advantages and capabilities thereof, reference is made to the following disclosure and appended claims in connection with the above- described drawings.

### Background of the Invention

Indium oxide (indium(III) oxide, In₂O₃), owing to the large band gap between 3.6 and 3.75 eV (measured for vapour-deposited layers) [H.S. Kim, P.D. Byrne, A. Facchetti, T.J. Marks; J. Am. Chem. Soc. 2008, 130, 12580-12581], is a promising semiconductor for charge transport in thin films. Thin films of a few hundred nanometres in thickness may additionally have a high transparency in the visible spectral range of greater than 90% at 550 nm. The transparency makes such thin films interesting candidates for thin devices that emit light.

Indium oxide is often used in particular together with tin(IV) oxide (SnO₂) as the semiconductive mixed oxide ITO. Owing to the comparatively high conductivity of ITO layers with the same transparency in the visible spectral range, one application thereof is in the field of liquid-crystal displays (LCDs) and organic light emitting diodes (OLEDs) as well as quantum dot light emitting diodes (QD LEDs), especially as a "transparent electrode". These usually doped metal oxide layers are produced industrially in particular by costly vapor deposition methods under high vacuum.

In addition to metal oxide-containing layers, especially indium oxide-containing layers and the production thereof, and among these ITO layers and pure indium oxide layers, are thus of great significance for the semiconductor and display industry.

V. Wood, M.J. Panzer, J.E. Halpert, J.-M. Caruge, M.G. Bawendi, V. Bulociv; ACS Nano, Vol. 3, No. 11, pages 3581 - 3586 describe the use of transparent ITO as conductive layer, together with nickel oxide, tungsten oxide, tin oxide, zinc tin oxide and zinc oxide for use as hole and electron transport layers in a light emitting flat device that uses quantum dots for the generation of the emitted light. In this publication the use of metal sulfides, such as Zinc Cadmium Sulfide and Zinc Sulfide is also described for use in flat light emitting devices that use quantum dots as emitters.
In addition to indium oxide-containing layers, especially nickel oxide, tungsten oxide, tin oxide, zinc tin oxide and zinc oxide containing layers and production thereof are thus of great significance for the semiconductor and display industry.

Possible reactants and precursors discussed for the synthesis of metal oxide-containing layers include a multitude of compound classes. Examples for the synthesis of indium oxide include indium salts. For instance, Marks et al. describe components produced using a precursor solution composed of InCl₃ and the base monoethanolamine (MEA) dissolved in methoxyethanol. After spin-coating of the solution, the corresponding indium oxide layer is obtained by thermal treatment at 400°C. [H.S. Kim, P.D. Byrne, A. Facchetti, T.J. Marks; J. Am. Chem. Soc. 2008, 130, 12580-12581 and supplemental information].

Elsewhere, possible reactants or precursors discussed for the metal oxide synthesis are metal alkoxides. A metal alkoxide is a compound consisting of at least one metal atom, at least one alkoxide radical of the formula -OR (R = organic radical) and optionally one or more organic radicals -R, one or more halogen radicals and/or one or more -OH or -OROH radicals.

Independently of a possible use for metal oxide formation, the prior art describes various metal alkoxides and metal oxo alkoxides. Compared to the metal oxides already mentioned, metal oxo alkoxides also have at least one further oxygen radical (oxo radical) bound directly to an indium atom or bridging at least two indium atoms.

Mehrotra et al. describe the preparation of indium trisalkoxide In(OR)₃ from indium(III) chloride (InCl₃) with Na-OR where R is methyl, ethyl, isopropyl, n-, s-, t-butyl and pentyl radicals. [S. Chatterjee, S. R. Bindal, R.C. Mehrotra; J. Indian Chem. Soc. 1976, 53, 867].

A review article by Carmalt et al. (Coordination Chemistry Reviews 250 (2006), 682-709) describes various gallium(III) and indium(III) alkoxides and aryloxides, some of which may also be present with bridging by means of alkoxide groups. Additionally presented is an oxo-centred cluster of the formula In₅(µ-O)(OⁱPr)₁₃, more specifically [In₅(µ₅-0)(µ₃-OⁱPr)₄(µ₂-OⁱPr)₄(OⁱPr)₅], which is an oxo alkoxide and cannot be prepared from [In(OⁱPr)₃].

A review article by N.Turova et al., Russian Chemical Reviews 73 (11), 1041-1064 (2004) summarizes synthesis, properties and structures of metal oxo alkoxides, which are considered therein as precursors for the production of oxidic materials via sol-gel technology. In addition to a multitude of other compounds, the synthesis and structure of [Sn₃O(OⁱBu)₁₀(ⁱBuOH)₂], of the already mentioned compound [In₅O(OⁱPr)₁₃] and of [Sn₆O₄(OR)₄] (R = Me, Prⁱ) are described.

The article by N. Turova et al., Journal of Sol-Gel Science and Technology, 2, 17-23 (1994) presents results of studies on alkoxides, which are considered therein as a scientific basis for the development of sol-gel processes of alkoxides and alkoxide-based powders. In this context, there is also discussion of a purported "indium isopropoxide", which was found to be the oxo alkoxide with a central oxygen atom and five surrounding metal atoms of the formula M₅(µ-O)(OⁱPr)₁₃ which is also described in Carmalt et al.

A synthesis of this compound and the crystal structure thereof are described by Bradley et al., J. Chem. Soc., Chem. Commun., 1988, 1258-1259. Further studies by the authors led to the result that the formation of this compound cannot be attributed to a hydrolysis of intermediately formed In(OⁱPr)₃ (Bradley et al., Polyhedron Vol. 9, No. 5, pp. 719-726, 1990). Suh et al., J. Am. Chem. Soc. 2000, 122, 9396-9404 additionally found that this compound is not preparable by a thermal route either from In(OⁱPr)₃. Moreover, Bradley (Bradley et al., Polyhedron Vol. 9, No. 5, pp. 719-726, 1990) found that this compound cannot be sublimed.

Metal oxide layers can in principle be produced via various processes.

One means of producing metal oxide layers is based on sputtering techniques. However, these techniques have the disadvantage that they have to be performed under high vacuum. A further disadvantage is that the films produced therewith have many oxygen defects, which make it impossible to establish a controlled and reproducible stoichiometry of the layers and hence lead to poor properties of the layers produced.

Another means in principle for producing metal oxide layers is based on chemical gas phase deposition. For example, it is possible to produce indium oxide-, gallium oxide- or zinc oxide-containing layers from precursors such as metal alkoxides or metal oxo alkoxides via gas phase deposition. For example US 6,958,300 B2 teaches using at least one metal organo oxide precursor (alkoxide or oxo alkoxide) of the generic formula M¹_{q}(O)ₓ(OR¹)_{y} (q = 1-2; x = 0-4, y = 1-8, M¹ = metal; e.g. Ga, In or Zn, R¹ = organic radical; alkoxide when x = 0, oxo alkoxide when ≥ 1) in the production of semiconductors or metal oxide layers by gas phase deposition, for example CVD or ALD. However, all gas phase deposition processes have the disadvantage that they require either i) in the case of a thermal reaction regime, the use of very high temperatures, or ii) in the case of introduction of the required energy for the decomposition of the precursor in the form of electromagnetic radiation, high energy densities. In both cases, it is possible only with a very high level of apparatus complexity to introduce the energy required to decompose the precursor in a controlled and homogeneous manner.

Advantageously, metal oxide layers are thus produced by means of liquid phase processes, i.e. by means of processes comprising at least one process step before the conversion to the metal oxide, in which the substrate to be coated is coated with a liquid solution of at least one precursor of the metal oxide and optionally dried subsequently. A metal oxide precursor is understood to mean a compound decomposable thermally or with electromagnetic radiation, with which metal oxide-containing layers can be formed in the presence or absence of oxygen or other oxidizing substances. Prominent examples of metal oxide precursors are, for example, metal alkoxides. In principle, the layer can be produced i) by sol-gel processes in which the metal alkoxides used are converted first to gels in the presence of water by hydrolysis and subsequent condensation, and then to metal oxides, or ii) from anhydrous solution.

The production of metal oxide-containing layers from metal alkoxides from the liquid phase also forms part of the prior art.

The production of metal oxide-containing layers from metal alkoxides via sol-gel processes in the presence of significant amounts of water forms part of the prior art. WO 2008/083310 A1 describes processes for producing inorganic layers or organic/inorganic hybrid layers on a substrate, in which a metal alkoxide (for example one of the generic formula R¹M-(OR²)_{y-x}) or a prepolymer thereof is applied to a substrate, and then the resulting metal alkoxide layer is hardened in the presence of, and reacting with, water. The metal alkoxides usable may include those of indium, gallium, tin or zinc. However, a disadvantage of the use of sol-gel processes is that the hydrolysis-condensation reaction is started automatically by addition of water and is controllable only with difficulty after it has started. When the hydrolysis-condensation process is started actually before the application to the substrate, the gels obtained in the meantime, owing to their elevated viscosity, are often unsuitable for processes for obtaining fine oxide layers. When the hydrolysis-condensation process, in contrast, is started only after application to the substrate by supply of water in liquid form or as a vapour, the resulting poorly mixed and inhomogeneous gels often lead to correspondingly inhomogeneous layers with disadvantageous properties.

JP 2007-042689 A describes metal alkoxide solutions which may contain indium alkoxides, and also processes for producing semiconductor components which use these metal alkoxide solutions.

The metal alkoxide films are treated thermally and converted to the oxide layer; these systems too, however, do not afford sufficiently homogeneous films. Pure indium oxide layers, however, cannot be produced by the process described therein.

DE 10 2009 009 338.9-43 describes the use of indium alkoxides in the production of indium oxide-containing layers from anhydrous solutions. Although the resulting layers are more homogeneous than layers produced by means of sol-gel processes, the use of indium alkoxides in anhydrous systems still has the disadvantage that the conversion of indium alkoxide-containing formulations to indium oxide-containing layers does not give sufficiently good electrical performance of the resulting layer.

It is thus an object of the present invention to provide a method for producing metal oxide-containing layers, which avoids the disadvantages of the prior art. More particularly, a method which avoids the use of high vacuum shall be provided, in which the energy required for the decomposition and conversion of precursors and reactants can be introduced in a simple, controlled and homogeneous manner, which avoids the disadvantages of sol-gel techniques mentioned, and which preferably leads to metal oxide layers with controlled, homogeneous and reproducible stoichiometry, high homogeneity and good electrical performance.

### Detailed description of the invention

One or more of these objectives can be achieved by the process and device of the present invention as defined in the claims and the description.

The process according to the present invention for preparing a device comprising a first layer and a first electrode, comprises a step of forming the first layer over a first electrode by applying a liquid anhydrous composition comprising
i) at least one metal oxo alkoxide of formula (I)

   MₓO_{y}(OR)_{z}[O(R'O)_{c}H]ₐX_{b}[R"OH]_{d} (I)

   where x = 3 to 25, y = 1 to 10, z = 3 to 50, a = 0 to 25, preferably a = 0, b = 0 to 20, preferably b = 0, c = 0 to 1, preferably c = 0, d = 0 to 25, preferably d = 0, and M = In, Zn, Ga, Y, Sn, Ge, Sc, Ti, Zr, Al, W, Mo, Ni, Cr, Fe, Hf, Ta, Nb and/or Cu, preferably M = In and/or Sn, R, R', R" = same or different organic radicals, and X = F, Cl, Br, I and
ii) at least one solvent,
onto a surface, the surface being selected from the surface of the first electrode or the surface of a layer being located over the first electrode, optionally drying the composition, and converting the composition to a metal oxide-containing first layer, and forming a second electrode over the first device layer, wherein the method further includes forming a layer comprising quantum dots over the first electrode before or after the formation of the first layer.

The liquid phase method according to the present invention for producing a metal oxide-containing first layer from a liquid anhydrous composition is a method comprising at least one process step in which the surface / substrate to be coated is coated with a liquid anhydrous composition comprising at least one metal oxo alkoxide of formula (I), preferably as a metal oxide precursor, and is then optionally dried. The process of the present invention is in particular not a process where the first layer is produced using a sputtering, CVD or sol-gel method. A metal oxide precursor is understood to mean a compound decomposable thermally or with electromagnetic radiation, with which metal oxide-containing layers can be formed in the presence or absence of oxygen or other oxidizing substances.

Liquid compositions in the context of the present invention are understood to mean those which are in liquid form under SATP conditions ("Standard Ambient Temperature and Pressure"; T = 25°C and p = 1013 hPa). A nonaqueous composition / anhydrous composition is understood here and hereinafter to mean a composition comprising not more than 200 ppm by weight of H₂O based on the total mass of the composition.

Advantageously, the present process includes formation of a first layer from a liquid anhydrous composition. Water would lead to non-desireable effects in device perparation and/or operation. Water can, for example, cause hydrolysis of the quantum dot material, can react with the ligands or result in quenching of the excited state or adversly affect the quantum dot device performance, without being limited to these effects.

Depending on the metal oxo alkoxides of formula (I) used, the product of the process according to the invention, the metal oxide-containing first layer, is understood to mean a metal- or semiconductor metal-containing layer which comprises indium, zinc, gallium, yttrium, tin, germanium, scandium, titanium, zirconium, aluminum, wolfram, molybdenum, nickel, chromium, iron, hafnium, tantalum, niobium or copper atoms or ions present essentially in oxidic form. Optionally, the metal oxide-containing first layer may also comprise carbene, halogen or alkoxide components from an incomplete conversion or an incomplete removal of by-products formed. The metal oxide-containing first layer may be a pure indium oxide, zinc oxide, gallium oxide, yttrium oxide, tin oxide, germanium oxide, scandium oxide, titanium oxide, zirconium oxide, aluminum oxide, wolfram oxide, molybdenum oxide, nickel oxide, chromium oxide, iron oxide, hafnium oxide, tantalum oxide, niobium oxide or copper oxide layer, i.e. neglecting any carbene, alkoxide or halogen components, may consist essentially of indium, zinc, gallium, yttrium, tin, germanium, scandium, titanium, zirconium, aluminum, wolfram, molybdenum, nickel, chromium, iron, hafnium, tantalum, niobium and copper atoms or ions present in oxidic form, or comprise proportions of further metals which may themselves be present in elemental or oxidic form. To obtain pure indium oxide, zinc oxide, gallium oxide, yttrium oxide, tin oxide, germanium oxide, scandium oxide, titanium oxide, zirconium oxide, aluminum oxide, wolfram oxide, molybdenum oxide, nickel oxide, chromium oxide, iron oxide, hafnium oxide, tantalum oxide, niobium oxide or copper oxide layers only indium, zinc, gallium, yttrium, tin, germanium, scandium, titanium, zirconium, aluminum, wolfram, molybdenum, nickel, chromium, iron, hafnium, tantalum, niobium or copper-containing precursors should be used in the process according to the invention, preferably only oxo alkoxides and alkoxides. In contrast, to obtain layers comprising other metals in addition to the metal-containing precursors, it is also possible to use precursors of metals in oxidation state zero (to prepare layers containing further metals in uncharged form) or metal oxide precursors (for example other metal alkoxides or oxo alkoxides).

Preferably the at least one metal oxo alkoxide used is an oxo alkoxide of the formula MₓO_{y}(OR)_{z} where M as defined above and x = 3 to 20, y = 1 to 8, z = 3 to 25, and OR are same or different C₁-C₁₅-alkoxy, -oxyalkylalkoxy, -aryloxy- or -oxyarylalkoxy groups, more preferably with x = 3 to 15, y = 1 to 5, z = 10 to 20, and OR same or different -OCH₃, -OCH₂CH₃, -OCH₂CH₂OCH₃, -OCH(CH₃)₂ or -OC(CH₃)₃. Most preferably the at least one metal oxo alkoxide of formula (I) used is [In₅(µ₅-O)(µ₃-OⁱPr)₄(µ₂-OⁱPr)₄(OⁱPr)₅], [Sn₃O(OⁱBu)₁₀(ⁱBuOH)₂] and/or, preferably or [Sn₆O₄(OR)₄]. It is preferred the at least one metal oxo alkoxide of formula (I) to be the sole metal oxide precursor in the process of the present invention. Very particularly good layers result are achieved when the sole metal oxide precursor is [In₅(µ₅-O)(µ₃-OⁱPr)₄(µ₂-OⁱPr)₄(OⁱPr)₅], [Sn₃O(O'Bu)₁₀(ⁱBuOH)₂] or [Sn₆O₄(OR)₄]. Among these layers, even further preference is given in turn to layers which have been produced using [In₅(µ₅-O)(µ₃-OⁱPr)₄(µ₂-OⁱPr)₄(OⁱPr)₅] as the sole metal oxide precursor.
The at least one metal oxo alkoxide of formula (I) is present in the anhydrous composition in an amount of from 0.1 to 15 % by weight, preferably of from 1 to 10 % by weight and most preferably of from 2 to 5 % by weight, based on the total mass of the anhydrous composition.

Any solvent except for water may be used in the composition used in the present invention. The composition may contain either a solvent or a mixture of different solvents. Preferably the at least one solvent is an aprotic or weakly protic solvent Preferred solvents are selected from the group of the aprotic nonpolar solvents, i.e. of the alkanes, substituted alkanes, alkenes, alkynes, aromatics without or with aliphatic or aromatic substituents, halogenated hydrocarbons or tetramethylsilane, and the group of the aprotic polar solvents, i.e. of the ethers, aromatic ethers, substituted ethers, esters or acid anhydrides, ketones, tertiary amines, nitromethane, DMF (dimethylformamide), DMSO (dimethyl sulfoxide) or propylene carbonate, and the weakly protic solvents, i.e. the alcohols, the primary and secondary amines and formamide. Solvents usable with particular preference are alcohols, and also toluene, xylene, anisole, mesitylene, n-hexane, n-heptane, tris(3,6-dioxaheptyl)amine (TDA), 2-aminomethyltetrahydrofuran, phenetole, 4-methylanisole, 3-methylanisole, methyl benzoate, N-methyl-2-pyrrolidone (NMP), tetralin, ethyl benzoate and diethyl ether. Very particularly preferred solvents are methanol, ethanol, isopropanol, tetrahydrofurfuryl alcohol, tert-butanol, 1-methoxy-2-propanol and derivatives and toluene, and mixtures thereof. Most preferred solvents that may be used as the at least one solvent are selected from the group consisting of methanol, ethanol, isopropanol, tetrahydrofurfuryl alcohol, tert.-butanol and toluene.

The anhydrous composition used in the present invention preferably has a viscosity at 20 °C of from 1 mPa·s to 10 Pa·s, more preferably of from 1 mPa·s to 100 mPa·s, most preferably of from 2 mPa·s to 50 mPa·s, determined to DIN 53019 parts 1 to 2 and measured at 20°C. Corresponding viscosities can be established by adding known viscosity modifiers, e.g. polymers, cellulose derivatives, or SiO₂ obtainable, for example, under the Aerosil® trade name from Evonik Resource Efficiency GmbH, and especially by use of PMMA, polyvinyl alcohol, urethane thickeners or polyacrylate thickeners.

The anhydrous composition is preferably applied to the surface by means of a printing process (especially flexographic/gravure printing, inkjet printing, offset printing, digital offset printing and screen printing), a spraying process, a rotary coating process ("spin-coating"), a dipping process ("dip-coating"), or a process selected from the group consisting of meniscus coating, slit coating, slot-die coating and curtain coating. The anhydrous composition is preferably applied to the surface by means of a printing process.

After the applying and before the conversion, the coated substrate can additionally be dried. Corresponding measures and conditions for this purpose are known to those skilled in the art.

The conversion to a metal oxide-containing layer can preferably be effected by a thermal route and/or by irradiation with electromagnetic, especially actinic, radiation. Preference is given to the conversion being effected thermally, preferably by means of temperatures of greater than 80°C. Particularly good results can be achieved, however, when temperatures of 81°C to 400°C are used for conversion. Preferably, conversion times of a few seconds up to several hours, i.e. from 2 seconds up to 24 hours are used.

The thermal conversion can additionally be promoted by introducing UV, IR or VIS radiation or treating the coated substrate with air, oxygen or other gases, i.e. nitrogen, argon, before, during or after the thermal treatment. Preferably UV, IR or VIS radiation is applied before, during or after the thermal treatment.

The quality of the layer obtained by the method according to the invention can additionally be improved further by a combined thermal and gas treatment (with H₂ or O₂), plasma treatment (Ar, N₂, O₂ or H₂ plasma), laser treatment (with wavelengths in the UV, VIS or IR range) or an ozone treatment, which follows the conversion step.
The layer comprising quantum dots might be deposited before or after the formation of the first layer. It might be advantageous to deposit the layer before the formation of the first layer. In another preferred embodiment of the process of the present invention the layer comprising quantum dots is deposited after the formation of the first layer.

In a preferred process of the present invention the process further comprises forming a second layer before or after formation of a layer comprising quantum dots, such that the layer comprising quantum dots is disposed between the first and second layers.

It might be advantageous that the first electrode is deposited on a substrate. The substrate is preferably selected from substrates comprising or preferably consisting of glass, metal, semiconductor, preferably silicon, silicon dioxide, preferably quartz, a metal oxide, preferably a transition metal oxide, a metal, a (mixed) metal oxide, a dielectric, paper, a wafer, or a polymeric material, preferably selected from polyethylene (PE), polypropylene (PP), polyethylene terephthalate (PET), polyethylene naphthalate (PEN), polyimide, polyether ether ketone (PEEK) and polyamide. The substrate used may be a rigid or flexible substrate, preferably a flexible substrate is used. Substrates including patterned ITO are commercially available and can also be used in making a device according to the present invention.

The process of the invention might further comprise steps of forming of other optional layers, including, for example, but not limited to, charge blocking layers, charge injecting layers, charge confinement layers, exciton confinement layers, etc., in/on the device.

With the process of the invention metal oxide-containing layers can be produced very easily. The metal oxide-containing layers producible by the process of the present invention are advantageously suitable for the production of electronic components, especially the production of thin light emitting devices that are using organic emitters or quantum dot materials as emitters. The device of the present invention comprises a first layer formed over a first electrode, the first layer comprising a metal oxide formed from a liquid anhydrous composition containing at least one metal oxide precursor, a second electrode over the first layer, and a layer comprising quantum dots disposed (arranged) between the first layer and one of the two electrodes.

The device according to the invention is preferably a light-emitting device or part of a light-emitting device. In a preferred device according to the invention the layer comprising quantum dots comprises an emissive material.

The first layer comprises as metal oxide indium oxide, zinc oxide, gallium oxide, yttrium oxide, tin oxide, germanium oxide, scandium oxide, titanium oxide, zirconium oxide, aluminum oxide, wolfram oxide, molybdenum oxide, nickel oxide, chromium oxide, iron oxide, hafnium oxide, tantalum oxide, niobium oxide or copper oxide, or mixtures thereof. Preferably the first layer comprises indium oxide.

The first device layer preferably has a thickness in a range of from 1 nm to 500 nm. Other thicknesses may be determined to be useful or desirable based on the particular device architecture and materials included in the device.

One of the electrodes may be formed on a substrate on which the device is built. In a preferred device according to the invention the first electrode is deposited onto a substrate.

The substrate can be opaque or transparent. A transparent substrate can be used, for example, in the manufacture of a transparent light emitting device. See, for example, Bulovic, V. et al., Nature 1996, 380, 29; and Gu, G. et al, Appl. Phys. Lett. 1996, 68, 2606- 2608, each of which is incorporated by reference in its entirety. The substrate can be rigid or flexible. The substrate may be selcted from many materials usable as substrate for an electrode. Preferbable substrates may be selected from: glass, plastic, preferably PE, PP, PET, PEN, Polyimide, PEEK, and Polyamide, quartz, metal, metal oxide, insulated metal foil, semiconductor, dielectric, paper, and wafer. The substrate can be a substrate commonly used in the art. Preferably the substrate has a smooth surface or may incorporate an additional palanrization layer. A substrate surface free of defects is particularly desirable. Substrates including patterned ITO are commercially available and can also be used in a device according to the present invention.

The first layer of preferred devices according to the invention is a charge transport layer. For example, the first layer may comprise a material capable of transporting electrons (also referred to herein as an electron transport layer) or the first device layer may comprise a material capable of transporting electrons and injecting electrons (also referred to herein as an electron transport and injection layer) or the first layer may comprise a material capable of transporting holes (also referred to herein as a hole transport layer). In a preferred device, a hole transport layer may also comprise a hole injection layer.

A preferred device according to the invention further includes a second layer, wherein the layer comprising quantum dots is disposed between the first and second device layers.

The device of the invention might further comprise other optional layers, including, for example, but not limited to, charge blocking layers, charge injecting layers, charge confinement layers, exciton confinement layers, etc.

The devices of the present invention might be or might not be part of light-emitting devices, thin-film transistors, photodetectors, sensors, preferably organic sensors, gas sensors or bio sensors, photovoltaic cells, backplanes for organic light emitting diodes, backplanes for quntum dot based light emitting devices, LCD devices, RFID tags, and ASICs. Depending on the selection of materials used to fabricate the device, such light-emitting device can be top-emitting, bottom-emitting, or both (e.g., by choosing the transparency of the contact conductors and other device layers).

Figure 4 provides a schematic representation of an example of one embodiment of a device in accordance with the present invention.

Referring to Figure 4, the depicted example of a device 10 includes a structure (from top to bottom) including a first electrode 1 (e.g., a cathode), a first charge transport layer 2 formed from a liquid anhydrous solution containing at least one metal oxide precursor in accordance with the invention (e.g., a layer comprising a material capable of transporting electrons (as referred to herein as an "electron transport layer"), a layer comprising quantum dots 3, an optional second charge transport layer 4 (e.g., a layer comprising a material capable of transporting or injecting holes (also referred to herein as a "hole transport material"), a second electrode 5 (e.g., an anode), and a substrate 6. A charge injecting layer (e.g., PEDOT:PSS) (now shown) can be disposed for example, between the second electrode and second charge transport layer. When voltage is applied across the anode and cathode, the anode injects holes into the hole injecting material while the cathode injects electrons into the electron transport material. The injected holes and injected electrons combine to form an excited state in the quantum dots which then relax and emit light.

In an example of another embodiment of a device in accordance with the present invention, a device can include a structure which includes (from top to bottom) an anode, a first charge transport layer comprising a material capable of transporting holes (as referred to herein as an "hole transport layer"), a layer comprising quantum dots, a second charge transport layer comprising a material capable of transporting electrons or injecting (as referred to herein as an "electron transport layer") formed from a liquid anhydrous solution containing at least one metal oxide precursor in accordance with the invention, a cathode, and a substrate. A hole injecting layer (e.g., PEDOT:PSS) (now shown) can be disposed for example, between the anode and first charge transport layer.

In another example, a first layer can be prepared on top of a layer comprising quantum dots (QD Layer) in a partially fabricated device by spin-casting a liquid anhydrous solution containing at least one metal oxide precursor on the QD layer and conversion same on a hotplate set at, e.g., 150°C, in air for about 30 min. (The partial device can further include a hole transport layer (e.g., TFB) under the QD layer and other device layers thereunder, such as, for example, those mentioned in the description of figure 4.) Following heating, the partial device can be moved into a vacuum oven in an inert-gas circulated glovebox to bake at a similar low temperature for another 30 min. Thereafter, in a thermal deposition chamber, a metal cathode contact can be formed thereover by either Ag or Al, or other metals; or a layer of conductive metal oxide is formed by sputtering; or by pasting certain cathode contact like Ag-paste. The device can thereafter preferably be encapsulated. For example, a device can be encapsulated by a cover with UV-curable epoxy.

Examples of other charge transport materials, hole injection materials, electrode materials, quantum dots (e.g., semiconductor nanocrystals), and other additional layers that may be optionally included in the device of the invention are described below.

The example of the device illustrated in Figure 4 can be a light emitting device wherein the layer comprising quantum dots comprises an emissive material. An example of a preferred light emitting device architecture is described in International Application No. PCT/US2009/002123, filed 3 April 2009, by QD Vision, Inc., et al, entitled "Light-Emitting Device Including Quantum Dots", which published as WO2009/123763 on 8 October 2009, which is hereby incorporated herein by reference in its entirely.

Other multilayer structures may optionally be used (see, for example, U.S. Patent Application Nos. 10/400,907 (now U.S. Patent No. 7,332,21 1) and 10/400,908 (now U.S. Patent No. 7,700,200), filed March 28, 2003, each of which is incorporated by reference in its entirety).

A device according to the invention may further comprise one or more additional sol-gel and/or non-sol-gel films. A non-sol-gel film may be organic, inorganic, hybrids, or mixtures thereof.
A layer of conductive contact composed of inactive metal (like Al, Ag, Au, e.g., by thermal decomposition) can be formed thereover or a layer of conductive metal oxides (like ITO, ÏZO etc.) can be formed thereover(e.g., by sputtering), as top contact, for the device.

The first electrode can be, for example, a cathode. A cathode preferably comprise a low work function (e.g., less than 4.0 eV) electron-injecting metal, such as Al, Ba, Yb, Ca, a lithium-aluminum alloy (Li:Al), a magnesium-silver alloy (Mg:Ag), or lithium fluoride-aluminum (LiF:Al). Other examples of cathode materials include silver, gold, ITO, etc. An electrode, such as Mg:Ag, can optionally be covered with an opaque protective metal layer, for example, a layer of Ag for protecting the cathode layer from atmospheric oxidation, or a relatively thin layer of substantially transparent ITO. An electrode can be sandwiched, sputtered, or evaporated onto the exposed surface of the substrate or a solid layer. In a preferred device the cathode can comprises silver.

The second electrode can be, for example, an anode. An anode can comprise a high work function (e.g., greater than 4.0 eV) hole-injecting conductor, such as an indium tin oxide (ITO) layer. Other anode materials include other high work function hole-injection conductors including, but not limited to, for example, tungsten, nickel, cobalt, platinum, palladium and their alloys, gallium indium tin oxide, zinc indium tin oxide, titanium nitride, polyaniline, or other high work function hole-injection conducting polymers. An electrode can be light transmissive or transparent. In addition to ITO, examples of other light-transmissive electrode materials include conducting polymers, and other metal oxides, low or high work function metals, conducting epoxy resins, or carbon nanotubes/polymer blends or hybrids that are at least partially light transmissive. An example of a conducting polymer that can be used as an electrode material is poly(ethlyendioxythiophene), sold by Bayer AG under the trade mark PEDOT. Other molecularly altered poly(thiophenes) are also conducting and could be used, as well as emaraldine salt form of polyaniline. In certain embodiments, the anode comprises aluminum. One or both of the electrodes can be patterned.

The electrodes of the device can be connected to a voltage source by electrically conductive pathways.

A quantum dot is a nanometer sized particle that can have optical properties arising from quantum confinement. The particular composition(s), structure, and/or size of a quantum dot can be selected to achieve the desired wavelength of light to be emitted from the quantum dot upon stimulation with a particular excitation source. In essence, quantum dots may be tuned to emit light across the visible spectrum by changing their size. See C.B, Murray, C.R. Kagan, and M.G. Bawendi, Annual Review of Material Sci., 2000, 30: 545-610 hereby incorporated by reference in its entirety. A quantum dot can comprise a core comprising one or more semiconductor materials and a shell comprising one or more semiconductor materials, wherein the shell is disposed over at least a portion, and preferably all, of the outer surface of the core. A quantum dot including a core and shell is also referred to as a "core/shell" structure.

In addition to the charge transport layers, a device may optionally further include one or more charge-injection layers, e.g., a hole-injection layer (either as a separate layer or as part of the hole transport layer) and/or an electron-injection layer (either as a separate layer as part of the electron transport layer). Charge injection layers comprising organic materials can be intrinsic (un-doped) or doped. A hole injecting layer can comprise PEDOT:PSS.

One or more charge blocking layers may further optionally be included. For example, an electron blocking layer (EBL), a hole blocking layer (HBL), or an exciton blocking layer (eBL), can be introduced in the structure. A blocking layer can include, for example, 3-(4-biphenylyl)-4-phenyl-5-tert butylphenyl-1,2,4-triazole (TAZ), 3,4,5- triphenyl- 1 ,2,4-triazole, 3 ;5-bis(4-tert-butylphenyl)- 4-pheny 1- 1 ,2,4-triazole, bathocuproine (BCP), 4,4',4"-tris{N-(3-methylphenyl)-N-phenylamino} triphenylamine (m-MTDATA), polyethylene dioxythiophene (PEDOT), 1,3- bis(5-(4-diphenylamino)phenyl-1,3,4-oxadiazol- 2-yl)benzene, 2-(4-biphenylyl)-5-(4-tertbutylphenyl)- 1,3,4-oxadiazole, 1,3-bis[5-(4-(I,I-dimethylethyl)phenyi)-1,3,4-oxadiazol-5,2-yl)benzene, 1,4-bis(5-(4-diphenylamino)phenyi- 1,3,4-oxadiazol-2-yl)benzene, 1 ,3,5-tris[5- (4-(I, I-dimethylethyl)phenyl)-1,3,4-oxadiazol-2- yl)benzene, or 2,2',2"-(1,3,5-Benztnetriyl)-tris(I-phenyl-1-H-benzimidazole) (TPBi). Charge blocking layers comprising organic materials can be intrinsic (un-doped) or doped.

Charge injection layers (if any), and charge blocking layers (if any) can for example be deposited by spin coating, dip coating, vapor deposition, or other thin film deposition methods. See, for example, M. C. Schlamp, et al., J. Appl. Phys,, 82, 5837-5842, (1997); V. Santhanam, et al., Langmuir, 19, 7881 -7887, (2003); and X. Lin, et al., J. Phys. Chem. B, 105, 3353-3357, (2001), each of which is incorporated by reference in its entirety.

In some applications, the substrate can further include a backplane. The backplane can include active or passive electronics for controlling or switching power to individual pixels or light-emitting devices. Including a backplane can be useful for applications such as displays, sensors, or imagers. In particular, the backplane can be configured as an active matrix, passive matrix, fixed format, direct drive, or hybrid. The display can be configured for still images, moving images, or lighting. A display including an array of light emitting devices can provide white light, monochrome light, or color-tunable light.

The device of the invention can further include a cover, coating or layer over the surface of the device opposite the substrate for protection from the environment (e.g., dust, moisture, and the like) and/or scratching or abrasion. In a further embodiment, the cover can further optionally include a lens, prismatic surface, etc. Anti-reflection, light polarizing, and/or other coatings can also optionally be included over the pattern. Optionally, a sealing material (e.g., UV curable epoxy or other sealant) can be further added around any uncovered edges around the perimeter of the device.

A preferred device of the invention is preferably prepared using the process according to the invention.

## Claims

1. A process for preparing a device comprising a first layer and a first electrode, the process comprising a step forming the first layer over a first electrode by applying a liquid anhydrous composition comprising
i) at least one metal oxo alkoxide of formula (I)
MₓO_{y}(OR)_{z}[O(R'O)_{c}H]ₐX_{b}[R"OH]_{d} (I)
where x = 3 to 25,
y = 1 to 10,
z = 3 to 50,
a = 0 to 25,
b = 0 to 20,
c = 0 to 1,
d = 0 to 25,
and M = In, Zn, Ga, Y, Sn, Ge, Sc, Ti, Zr, Al, W, Mo, Ni, Cr, Fe, Hf, Ta, Nb and/or Cu, R, R', R" = same or different organic radicals, and X = F, Cl, Br, I and
ii) at least one solvent,
onto a surface, the surface being selected from the surface of the first electrode or the surface of a layer being located over the first electrode, optionally drying the composition, and converting the composition to a metal oxide-containing first layer, and forming a second electrode over the first device layer, wherein the method further includes forming a layer comprising quantum dots over the first electrode before or after the formation of the first layer.

2. A process according to claim 1, **characterized in that** the at least one metal oxo alkoxide used is an oxo alkoxide of the formula MₓO_{y}(OR)_{z} where x = 3 to 20, y = 1 to 8, z = 3 to 25, and OR same or different C₁-C₁₅-alkoxy, -oxyalkylalkoxy, -aryloxy- or -oxyarylalkoxy groups, more preferably with x = 3 to 15, y = 1 to 5, z = 10 to 20, and OR same or different -OCH₃, - OCH₂CH₃, -OCH₂CH₂OCH₃, -OCH(CH₃)₂ or -OC(CH₃)₃.

3. A process according to claim 1 or 2, **characterized in that** the at least one metal oxo alkoxide of formula (I) is [In₅(µ₅-O)(µ₃-OⁱPr)₄(µ₃-OⁱPr)₄(OⁱPr)₅], [Sn₃O(OⁱBu)₁₀(ⁱBuOH)₂] and/or [Sn₆O₄(OR)₄].

4. A process according to any one of the preceding claims, **characterized in that** the at least one metal oxo alkoxide is the sole metal oxide precursor used in the process.

5. A process according to any one of the preceding claims, **characterized in that** the at least one metal oxo alkoxide of formula (I) is present in proportions of 0.1 to 15% by weight, based on the total mass of the anhydrous composition.

6. A process according to any one of the preceding claims, **characterized in that** the at least one solvent is an aprotic or weakly protic solvent.

7. A process according to any one of the preceding claims, **characterized in that** the at least one solvent was selected from the group consisting of methanol, ethanol, isopropanol, tetrahydrofurfuryl alcohol, tert-butanol and toluene.

8. A process according to any one of the preceding claims, **characterized in that** the composition has a viscosity of 1 mPa·s to 10 Pa·s.

9. A process according to any one of the preceding claims, **characterized in that** the anhydrous composition is applied to the surface by means of a printing process, a spraying process, a rotary coating process, a dipping process, or a process selected from the group consisting of meniscus coating, slit coating, slot-die coating and curtain coating.

10. A process according to any one of the preceding claims, **characterized in that** the conversion is effected thermally by means of temperatures greater than 80°C.

11. A process according to claim 10, **characterized in that** UV, IR or VIS radiation is applied before, during or after the thermal treatment.

12. A process according to any one of the preceding claims, **characterized in that** the layer comprising quantum dots is deposited before the formation of the first layer.

13. A process according to any one of the preceding claims, **characterized in that** the layer comprising quantum dots is deposited after the formation of the first layer.

14. A process according to any one of the preceding claims, **characterized in that** the process further comprises forming a second layer before or after formation of a layer comprising quantum dots, such that the layer comprising quantum dots is disposed between the first and second layers.

15. A process to any one of the preceding claims, **characterized in that** the first electrode is deposited on a substrate, the substrate preferably being selected from substrates comprising or preferably consisting of glass, metal, semiconductor, preferably silicon, silicon dioxide, preferably quartz, a metal oxide, preferably a transition metal oxide, a metal, a dielectric, paper, a wafer, or a polymeric material, preferably selected from polyethylene (PE), polypropylene (PP), polyethylene terephthalate (PET), polyethylene naphthalate (PEN), polyimide, polyether ether ketone (PEEK) and polyamide.

16. A device comprising a first layer formed over a first electrode, the first layer comprising a metal oxide formed from a liquid anhydrous composition containing at least one metal oxide precursor, a second electrode over the first layer, and a layer comprising quantum dots disposed between the first layer and one of the two electrodes.

17. A device according to claim 16, **characterized in that** the device is a light-emitting device or is part of a light-emitting device.

18. A device according to claim 16 or 17, **characterized in that** the metal oxide comprises indium oxide, zinc oxide, gallium oxide, yttrium oxide, tin oxide, germanium oxide, scandium oxide, titanium oxide, zirconium oxide, aluminum oxide, wolfram oxide, molybdenum oxide, nickel oxide, chromium oxide, iron oxide, hafnium oxide, tantalum oxide, niobium oxide or copper oxide, or mixtures thereof.

19. A device according to any one of claims 16 to 18, **characterized in that** the first electrode is deposited onto a substrate.

20. A device according to any one of claims 16 to 19, **characterized in that** the first layer is a charge transport layer.

21. A device according to any one of claims 16 to 20, **characterized in that** the device further includes a second layer, wherein a layer comprising quantum dots is disposed between the first and second layers.

22. A device according to any one of claims 16 to 21 prepared in accordance with a process according to any one of claims 1 to 15.
